# EUROPEAN PATENT APPLICATION

(11) **EP 4 804 758 A1**
(43) Date of publication of application: **09.09.2026**
(21) Application number: 26159266.1
(22) Date of filing: 18.02.2026
(51) Int. Cl.: H10D 30/66, H10D 12/00, H10D 12/01, H10D 30/01, H10D 62/10, H10D 62/13, H10D 64/27

(54) **VERTICAL POWER SEMICONDUCTOR DEVICE WITH A FIN-TYPE STRUCTURE AND CONTACT REGIONS LOCATED BETWEEN THE FINS**

(30) Priority: 18.02.2025 CN 202510174535
(71) Applicant: SwissSEM Technologies AG, 5600 Lenzburg (CH); Sun.King Pacific Semiconductors Technology (Zhejiang) Co.,Ltd, Jiaxing City, Zhengjiang 314100 (CN)
(72) Inventor: REIGOSA DIAZ, Paula, 5600 Lenzburg (CH); SCHNEIDER, Nick, 5600 Lenzburg (CH); KNOLL, Lars, 5600 Lenzburg (CH)
(74) Representative: Kuhnen & Wacker Patent- und Rechtsanwaltsbüro PartG mbB

(57) **Abstract**

This invention discloses a vertical power semiconductor device, MOSFET or IGBT, designed to reduce conduction losses and optimize device performance. The device comprises an array of cells, the cells including: a drift layer (3) formed on a substrate (2); a fin structure (3, 8, 7, 6) protruding from the substrate, which is composed of stacked regions of different conductivity types with a body region (7), a source/emitter region (6) and a carrier spreading layer (8); a gate recess formed between adjacent fins; a gate (not shown) that covers the fins on three sides and is isolated from the fins through a dielectric layer (9 in fig. 4), with the fins laterally sandwiched between the recesses (5), the recess depth extending deeper than the carrier spreading layer (8). A longitudinal spacing between adjacent recesses is smaller than about 1 µm, and source/emitter and drain contact regions are formed on opposite sides of the substrate. The source/emitter contacts (1) have a are formed in as stripes that are perpendicular to the gate trenches. This invention reduces the JFET effect by interrupting the gate in the source contact region, thereby achieving low conduction loss and improved performance.

## Description

### FIELD OF THE INVENTION

The present invention relates to the field of power semiconductor devices. Power semiconductor devices that can withstand a blocking voltage of several hundred volts are typically implemented as vertical structures. The semiconductor wafer is based on semiconductor materials such as silicon, silicon carbide, or gallium nitride. The present invention discloses a novel structure, wherein a device having the characteristics presented in the claims allows for a device with low on-state losses, high cell packing density, and reduced electric field stress on the gate oxide.

### BACKGROUND OF THE INVENTION

Medium voltage power semiconductor devices can be realized with planar and recess MOS cell designs, such as IGBT and MOSFET designs. These devices feature a gate contact which is electrically isolated from the rest of the transistor structure by an appropriate dielectric material (for example, silicon dioxide), which is used to control the device and switch it from blocking to conducting state, or vice versa. They are typically fabricated with a layer structure, which is arranged between a source electrode on the source side and a drain electrode on the opposite side. An N-doped drift layer is arranged in between the drain and source electrodes. On the source side, a P-doped base layer is in direct contact to the source electrode. An N-doped source region is embedded into the base layer and via an opening, it is contacted to the source electrode.

The recess cell concept is typically used to lower the on-state resistance, increase the packing density, and widen the channel width to optimize the device and achieve a better technology curve. However, the recess structure suffers from lower blocking capability due to the high electric fields at the bottom corners of the recesses. Also, an increased capacitance results in bad controllability and high switching losses, and because of high cell density in the recess design, a high short-circuit current is expected. Therefore, many designs to optimize the device structure have been proposed, with particular focus on the regions between the active MOS cells. The advantage is that the on-state conduction losses can be reduced by decreasing the distance between the recesses (also called mesa). These device optimizations have been addressed for IGBTs and MOSFETs (both Si and SiC) [1-4]:
[1] EP 3227924 B1 Power Semiconductor Device;
[2] Proc. ISPSD 2023 Proposal of Vertical-channel Fin-SiC MOSFET toward Future Device Scaling
[3] GB 2587645 A Semiconductor Device having a gate electrode formed in a recess structure
[4] US 0216331 Semiconductor Device and Method for Designing Thereof

In [2] a silicon carbide recess-etched double-implanted MOS (SiC TED MOS) has been proposed, where three channel types have been suggested to increase the channel mobility and improve R_{ON}A. Basically, the current flows horizontally as with a planar cell concept, but adding some benefits from the recess-cell concept. The drawback of such design is the long channel length required, which reduces the on-state current, and thus, it requires large areas for its cells and JFET regions must be carefully taken care of.

In [1], a silicon carbide recess field effect transistor device with double gate is proposed, where the current flows vertically. The semiconductor is arranged in a plurality of vertical field effect transistor cells including a body region surrounded by the gate layer, where the distance between the two lateral surfaces is 1µm or less. In this design, the current flows vertically, but because of the large JFET effect, the electrons are diverted horizontally before reaching the drain contact, which increases the on-state resistance.

### SUMMARY OF THE INVENTION

To solve the above problems, the present invention provides a semiconductor power device with low conduction loss, stable gate parameters, improved blocking capability, and good controllability.

The invention is set out in the appended claims.

To achieve the above objectives, exemplary embodiments of the present invention provide a semiconductor device, comprising a plurality of arranged cells, the cells comprising:
a drift layer formed by a substrate of a first conductivity type;
a fin structure, arranged on a first main side of the substrate and protruding in a y direction above the semiconductor surface, is stacked from top to bottom with a first conductivity type region, a second conductivity type body region, and a first conductivity type carrier spreading layer region;
a recess is formed between two adjacent fin structures, and the distance between the recesses forms a mesa;
a gate, wrapped around the fin structure and isolated from the fin structure by a gate dielectric layer, wherein each fin structure is laterally sandwiched between two recesses in the x direction, and the depth of the recess is greater than or equal to the position of the first conductivity type carrier spreading layer region; the distance between two longitudinally adjacent recesses in the z direction is less than or equal to 1µm;
a contact region is formed on the first main side of the substrate and connected to the source or emitter electrode of the semiconductor device; and
a contact region is formed on the second main side of the substrate and connected to the drain electrode of the semiconductor device.

The width between two laterally adjacent recesses in the x direction is d1, d1 is in the sub-micron or micron range (exemplarily d1 may be less than or equal to 1 µm), and the recess is interrupted by the contact region of the source or emitter electrode in the z direction, the interruption width is d2, and the width d1 < width d2.

In a further embodiment, the semiconductor device includes a second conductivity type blocking region, wherein the second conductivity type blocking region is implanted at the bottom of the recess and is floating;

Alternatively, the second conductivity type blocking region can also be implanted at the bottom of the recess and be electrically contacted. The electrical contact means that the second conductivity type blocking region is electrically connected to the contact region of the source or emitter electrode. The electrical contact of the second conductivity type blocking region is formed by etching the middle part of the recess, thereby defining the potential of the second conductivity type blocking region.

In another embodiment, the gate dielectric layer covering the fin structure comprises a recess top dielectric layer, a fin structure top dielectric layer, and a fin structure side dielectric layer, and the thicknesses of the recess top dielectric layer, the fin structure top dielectric layer, and the fin structure side dielectric layer are different.

Meanwhile, the gate dielectric layer may extend to the contact region of the source or emitter electrode and overlap with the contact region of the source or emitter electrode in the y direction, or may not extend to the contact region of the source or emitter electrode as needed.

In some different embodiments, the cells are arranged in a hexagonal shape.

The semiconductor device designed in the present invention has a three-dimensional layout structure in the region of the vertical channel, that is, the described fin structure, which is surrounded by the gate electrode and the recess. Although the distance between the recesses is in the range of 1µm or less, resulting in a significantly larger JFET effect. However, the gate is interrupted in the area where the source contact is arranged, and the distance between the two gates in this area is larger, thereby eliminating the JFET effect. Therefore, this semiconductor device has the advantage of low conduction loss brought by the reduced recess and avoids the disadvantage of increased on-resistance.

### BRIEF DESCRIPTION OF THE DRAWINGS

FIG. 1 is a top view of Embodiment 1.
FIG. 2 is a three-dimensional view of Embodiment 1.
FIG. 3 is a top view of Embodiment 2.
FIG. 4 is a cross-sectional view of cut A-A in FIG. 3.
FIG. 5 is an enlarged view of the fin structure.
FIG. 6 is a schematic diagram of the structure of Embodiment 3.
FIG. 7 is a top view of the prior art.

### DETAILED DESCRIPTION OF THE EMBODIMENTS

The following describes preferred embodiments of the present invention in conjunction with the accompanying drawings. It should be understood that the preferred embodiments described herein are for illustration and explanation of the present invention only, and are not intended to limit the present invention.

### Embodiment 1

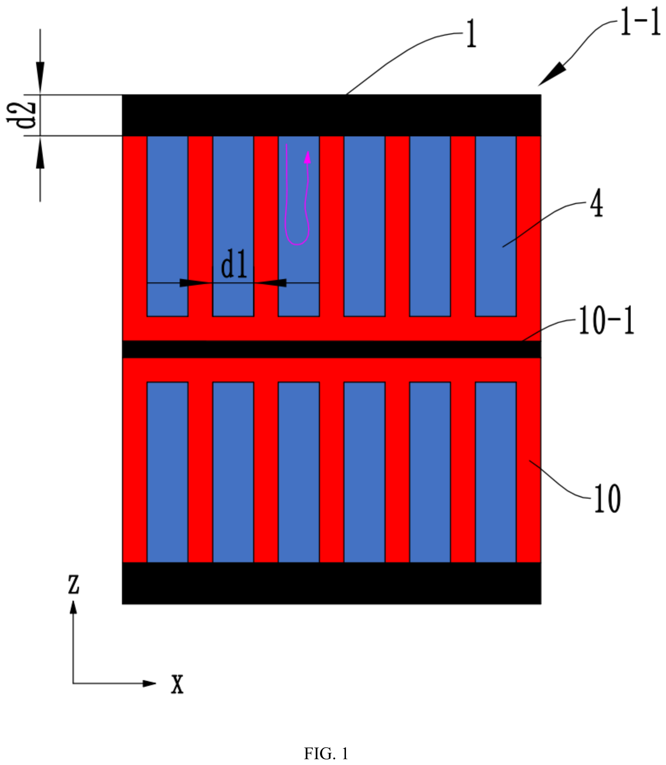

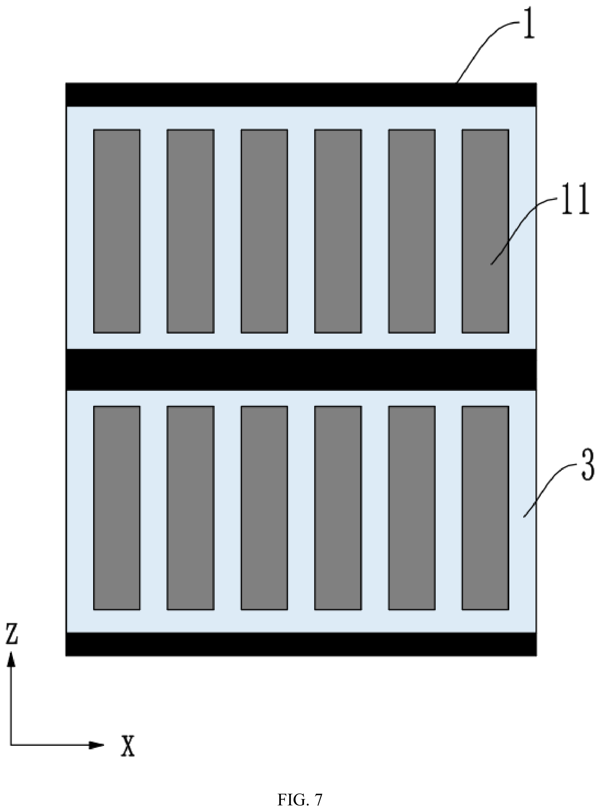

As shown in Figure 1, the semiconductor device described in this embodiment includes a semiconductor having layers of different conductivity types arranged between a source 1 on one side and a drain 2 on the other side. A substrate of a first conductivity type forms a drift layer 3. Recessed region 5 are formed by selectively etching the substrate to a certain depth, thereby forming micron or submicron-scale fin structures 4 that protrude above the substrate between two adjacent recesses 5. Naturally, a plurality of fin structures 4 will be formed between multiple recesses 5. Figure 1 presents one of the embodiments of the present invention, but is not the preferred embodiment for carrying out the present invention. Its layout is similar to the prior art shown in Figure 7, wherein recesses 5 are arranged around vertical field-effect transistor cells, forming a plurality of fin structures 4. It should be noted that the structure of Figure 1 repeats in the z-direction and in the x direction. That means that only a part of the semiconductor device is shown in Figure 1.

The fin structure 4 includes, from top to bottom: a first conductivity type region 6 (N+ source), a second conductivity type body region 7 (P+ body), and a first conductivity type carrier spreading layer region 8 (N+ CSL). The first conductivity type region 6 is a highly doped region, the first conductivity type carrier spreading layer region 8 is also a highly doped region, and the doping concentration of the first conductivity type carrier spreading layer region 8 is higher than that of the drift layer 3. At the same time, the outside of the fin structure 4 is covered by the dielectric layer of the gate 11.

The function of the first conductivity type carrier spreading layer region 8 is to conduct electrons to a region where there is no JFET effect. The gate dielectric layer 9 is connected to the gate 11 electrode of the device through a layer of conductive material (such as highly doped polysilicon). By modulating the voltage applied to the gate 11 electrode, a vertical MOS channel can be formed in the fin structure 4, switching the semiconductor device from the blocking state to the conducting state, and vice versa.

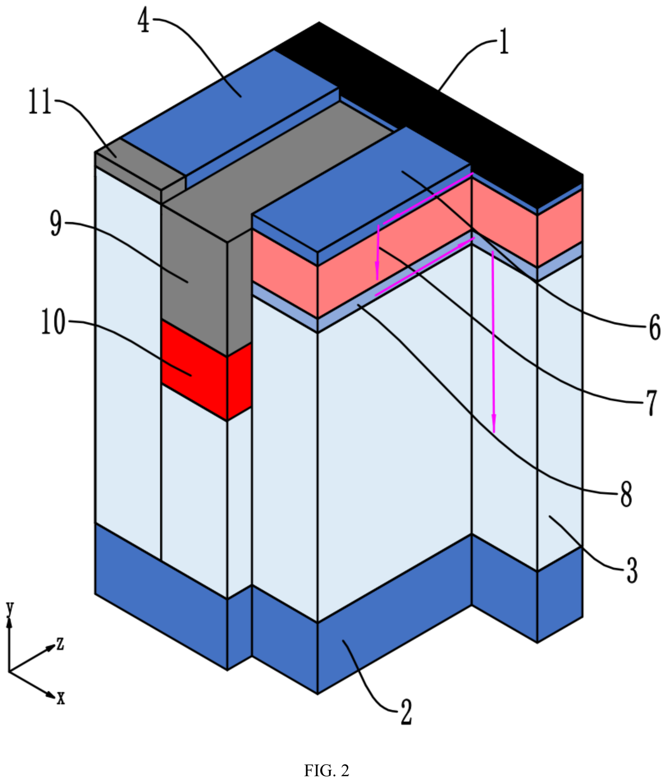

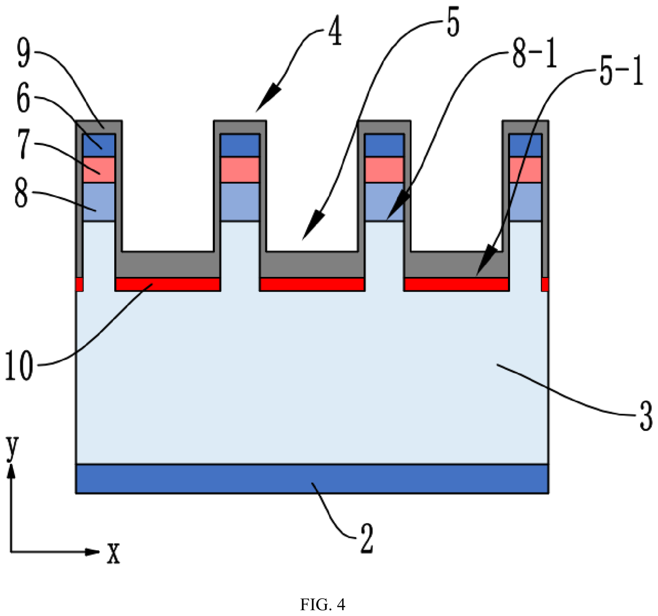

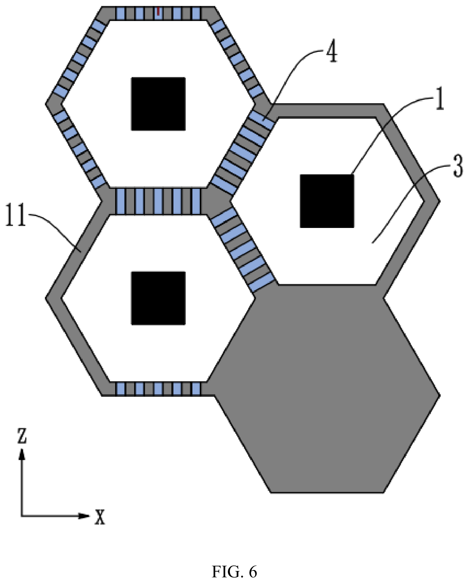

At the same time, as shown in Figure 2, the height of the fin structure 4 in the y direction is defined by the depth of the etching on the substrate. In this embodiment, the recess 5, that is, the upper surface 5-1 of the recess 5, is lower than the lower surface 8-1 of the first conductivity type carrier spreading layer region 8. With regard to a cross-section perpendicular to the z-direction through the fin structures 4 it may also be referred to the cross-sections of the second embodiment as shown in Figures 4 and 6. In these figures, for the sake of clarity, only the gate dielectric 9 is shown, but not the gate 11 electrode.

It should be noted that, for clarity, Figure 2 presents the various elements of the semiconductor device in partial cross-section; that is, only portions of the different elements are depicted.

The distance between two adjacent recesses 5, that is, the minimum width of the fin structures 4 between two adjacent recesses 5, is d1, which defines the mesa width of the semiconductor device. Reducing the mesa width d1 can increase the recess 5 density, thereby improving device performance.

The fin structures 4 are arranged in the x direction at a micron or submicron pitch to form the mesa, while the recesses 5 are interrupted in the z direction by the contact region 1-1 where the source 1 or emitter is arranged, forming a region with a larger distance between the recesses 5. The interruption width of 1-1 is d2, and the size of the width d2 is less than or equal to 1µm, and generally the width d2 is much larger than the width d1. The x direction, the y direction and the z direction may be directions perpendicular to each other as shown in the figures.

When the width of the fin structure 4 is small, that is, the width d1 is small, there will be a large JFET effect, so the electron path will be deflected, as shown in Figure 1, the electron flow path is deflected in the z direction. In the y direction, as shown in Figure 2, the electrons first flow in the z direction through the first conductivity type region 6, that is, the N+ source region, and then flow vertically through the second conductivity type body region 7, that is, the P+ body region, to the first conductivity type carrier spreading layer region 8, that is, the N+ CSL region, and then turn back in the z direction to flow along the first conductivity type carrier spreading layer region 8 (opposite to the direction in the first z direction) until the electrons reach a region where the JFET effect is extremely low or does not exist. That is, the region where the distance between the recesses 5 is larger, as shown in Figure 2, returns to the area below the contact 1-1 where the source 1 is arranged. In this way, the electrons can flow longitudinally again in the y direction to the drain 2.

The advantage of this structure is that the electric field at the bottom of the recess 5 is low, which means that the oxide forming the gate dielectric layer 9 is not affected by too much electric field during the turn-off operation.

In addition, in some embodiments, a second conductivity type blocking region 10 (P+ blocking) can be provided below the recess 5. By providing an additional highly doped blocking layer, the static and dynamic electric fields, especially high electric fields, experienced by the gate dielectric layer 9 are further reduced. At the same time, the majority carriers will not flow around the second conductivity type blocking region 10.

In the optimal embodiment, the second conductivity type blocking region 10 is floating, that is, electrically isolated from the source 1. In other embodiments, it can be electrically connected to the source 1 of the semiconductor device.

### Embodiment 2

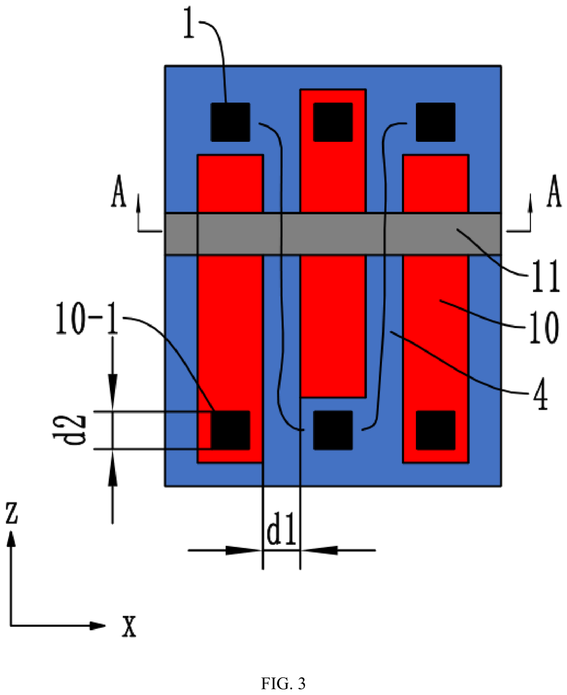

As shown in Figures 3-5, the semiconductor device described in this embodiment is a preferred embodiment of the present invention. As shown in Figure 3, the semiconductor device described in this embodiment is slightly different from the semiconductor device disclosed in Figure 1 in a top view, but the concepts are the same. The second conductivity type blocking region 10 has a contact 10-1, which is made by etching the middle position of the recess 5, and the potential of the second conductivity type blocking region 10 can be controlled by the contact 10-1. The source 1 and the contact 10-1 of the second conductivity type blocking region 10 are arranged in an interlaced manner, so the corresponding fin structures 4 also form an interlaced layout.

At the same time, Figure 3 also shows the path of the electron current, starting from the source 1, under the action of the gate 11, through the vertical channel composed of the first conductivity type region 6 and the second conductivity type body region 7, flowing in the longitudinal y direction to the first conductivity type carrier spreading layer region 8, and then flowing horizontally in the z direction on the first conductivity type carrier spreading layer 8 until the electrons reach the area without JFET effect, as shown in Figure 3 on the other side of the source 1, and finally flowing longitudinally to the drain 2.

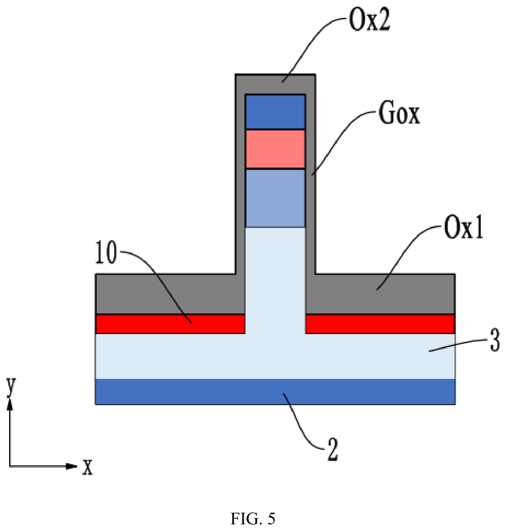

As shown in Figures 4 and 5, a second conductivity type blocking region 10 is provided at the bottom of the recess 5. And the gate dielectric layer 9 surrounding the fin structure 4 has different thicknesses corresponding to different surfaces of the fin structure 4, that is, the bottom position of the recess 5, the top position of the fin structure 4, and the position on the side of the fin structure 4. The gate dielectric layer 9 covering the fin structure 4 comprises a recess top dielectric layer Ox1 at the bottom of the recess, a fin structure top dielectric layer Ox2 on the top of the fin structure 4, and a fin structure side dielectric layer Gox on the side of the fin structure 4. Preferably, the thicknesses of these three different layers Ox1, Ox2 and Gox are different. Specifically, the recess top dielectric layer Ox1 may have a greater thickness than the fin structure to dielectric layer Ox2 and the fin structure side dielectric layer Gox as shown in Figure 5.

### Embodiment 3

As shown in Figure 6, the semiconductor device described in this embodiment is a multi-cell arrangement structure composed of hexagonal transistor cells 12, and the gate 11 can be located in the recess 5 forming the fin structure 4. A plurality of fin structures 4 interconnect the source 1 contact regions.

In the description of the present invention, it should be noted that the xyz axes are all directions marked in the drawings, and the terms "vertical," "up," "down," "horizontal," etc. indicating the orientation or positional relationship are based on the orientation or positional relationship shown in the drawings, and are only for the convenience of describing the present invention and simplifying the description, rather than indicating or implying that the device or element referred to must have a specific orientation, be constructed and operated in a specific orientation, and therefore cannot be understood as a limitation of the present invention.

In the description of the present invention, it should also be noted that, unless otherwise expressly provided and limited, the terms "set", "mounted", "connected", and "connection" should be understood in a broad sense, for example, they can be fixed connections, or detachable connections, or integrally connected; they can be mechanical connections, or electrical connections; they can be directly connected, or indirectly connected through an intermediate medium, or they can be connected inside two elements. For those skilled in the art, the specific meaning of the above terms in the present invention can be understood according to the specific circumstances.

Finally, it should be noted that: the above description is only a preferred embodiment of the present invention, and is not intended to limit the present invention. Although the present invention has been described in detail with reference to the foregoing embodiments, those skilled in the art can still modify the technical solutions described in the foregoing embodiments, or make equivalent substitutions for some of the technical features. Any modifications, equivalent substitutions, or improvements made within the spirit and principles of the present invention shall be included within the scope of protection of the present invention.

## Claims

1. A semiconductor device, comprising a plurality of arranged cells, the cells comprising:
a drift layer (3) formed by a substrate of a first conductivity type;
a fin structure (4), arranged on a first main side of the substrate and protruding in a y direction above the first main side, the fin structure (4) being stacked from top to bottom with a first conductivity type region (6), a second conductivity type body region (7), and a first conductivity type carrier spreading layer region (8);
a recess (5) which is formed between two adjacent fin structures (4); and
a gate (11), wrapped around the fin structure (4) and being isolated from the fin structure (4) by a gate dielectric layer (9), wherein:
each fin structure (4) is laterally sandwiched between two recesses (5) in the x direction and has a width d1 in the x direction which is in the sub-micron or micron range,
the depth of each recess (5) is greater than or equal to the depth of the first conductivity type carrier spreading layer region (8),
the distance between two longitudinally adjacent recesses (5) in the z direction is less than or equal to 1µm,
a first contact region (1-1) is formed on the first main side of the substrate and connected to a source or emitter (1) electrode of the semiconductor device,
a second contact region is formed on a second main side of the substrate and connected to a drain (2) electrode of the semiconductor device, and
the recesses (5) are interrupted by the first contact region (1-1) of the source or emitter (1) electrode in the z direction, the interruption width being d2, wherein d1 < d2.

2. The semiconductor device according to claim 1, further comprising a second conductivity type blocking region (10), wherein the second conductivity type blocking region (10) is implanted at a bottom of each recess (5) and is floating.

3. The semiconductor device according to claim 1, further comprising a second conductivity type blocking region (10), wherein the second conductivity type blocking region (10) is implanted at a bottom of each recess (5) and is electrically contacted.

4. The semiconductor device according to claim 3, wherein the second conductivity type blocking region (10) is electrically connected to the first contact region (1-1) of the source or emitter (1) electrode.

5. The semiconductor device according to claim 4, wherein the electrical contact of the second conductivity type blocking region (10) is formed by etching a middle part of the gate (11) in the recess (5).

6. The semiconductor device according to any one of claims 1 to 5, wherein: the gate dielectric layer (9) covering the fin structure (4) comprises a recess top dielectric layer (Ox1), a fin structure top dielectric layer (Ox2), and a fin structure side dielectric layer (Gox), and the thicknesses of the recess top dielectric layer (Ox1), the fin structure top dielectric layer (Ox2), and the fin structure side dielectric layer (Gox) are different from each other.

7. The semiconductor device according to claim 6, wherein the gate dielectric layer (9) extends to the first contact region (1-1) of the source or emitter (1) electrode and overlaps with the first contact region (1-1) of the source or emitter (1) electrode in the y direction, or does not extend to the first contact region (1-1) of the source or emitter (1) electrode.

8. The semiconductor device according to any one of claims 1 to 7, wherein the cells are arranged in a hexagonal shape.
